# EUROPEAN PATENT SPECIFICATION

(11) **EP 1 542 262 B1**
(45) Date of publication and mention of the grant of the patent: **02.05.2007**
(21) Application number: 05002941.2
(22) Date of filing: 29.05.1998
(51) Int. Cl.: H01L 21/00, H01L 21/306, H01L 21/311

(54) **Processing method and apparatus for removing oxide film**
Verfahren zur Entfernung von einem Oxyd-Film und Einrichtung dafür
Dispositif et procédé pour le retrait d'un film d'oxyde

(30) Priority: 04.06.1997 JP 16188197
(43) Date of publication of application: 15.06.2005
(62) Divisional of application: 98109891.6
(73) Proprietor: TOKYO ELECTRON LIMITED, Minato-ku, Tokyo 107-8481 (JP)
(72) Inventor: Kobayashi, Yasuo, Tokyo 107-8481 (JP)
(74) Representative: HOFFMANN EITLE

(56) References cited:
- US-A- 4 689 112
- US-A- 5 273 609
- US-A- 5 328 558
- US-A- 5 474 615
- US-A- 5 620 559
- PATENT ABSTRACTS OF JAPAN vol. 017, no. 463 (E-1420), 24 August 1993 (1993-08-24) -& JP 05 109683 A (MITSUBISHI MATERIALS CORP), 30 April 1993 (1993-04-30)

## Description

The present invention relates to a processing method and apparatus for removing an oxide film formed on a surface of an object to be treated mainly such as a semiconductor wafer, particularly, to a processing method and apparatus for removing a thin oxide film such as a native oxide film formed on a surface of the object such as a semiconductor wafer, and more particularly, to a processing method and apparatus for removing a native oxide film formed in a bottom portion of a fine hole formed on a surface of the object such as a semiconductor wafer.

The present invention is directed mainly to a technique of removing an oxide film formed on a surface of an object such as a semiconductor wafer, particularly, to a technique for removing a native oxide film. Although, the object to be processed in the present invention is not limited to a semiconductor wafer, the related art in relation to a technique for removing a native oxide film formed in a bottom portion of a fine hole formed on a surface region of a semiconductor wafer in order to specifically describing the related art is described.

As widely known to the art, processes to form a film on a semiconductor wafer used as a substrate and etching treatments to selectively etch the resultant film in a predetermined pattern are repeatedly carried out in the manufacture of a semiconductor integrated circuit on the semiconductor wafer. During these processes, the substrate is transferred among various processing devices. During the transfer, the substrate is exposed to the air atmosphere, with the result that the oxygen and water within the air atmosphere unavoidably cause a native oxide film to be formed on a surface of the substrate. Formation of the native oxide film causes the properties such as electrical properties of the film on a surface of the substrate to be deteriorated. Where deterioration of the film properties is undesirable in the process for forming a film on the substrate or in the etching process of the film, it is necessary to remove the native oxide film formed on the substrate.

A wet etching is one of the conventional techniques for removing the native oxide film. In the wet etching, the semiconductor substrate (wafer) having a native oxide film formed thereon is immersed in a washing liquid for removing the native oxide film. It should be noted that the line width of a wiring and the diameter of a contact hole formed in the semiconductor wafer are diminished with increase in the scale of integration and miniaturization of the semiconductor integrated circuit. For example, the diameter of the contact hole is 0.2 to 0.3 µm or less. What should be noted is that, since the contact hole has a very small diameter, the washing liquid is unlikely to enter sufficiently the contact hole. Also, the washing liquid once entering the contact hole is not likely to be easily expelled from within the contact hole because of the surface tension of the washing liquid. Under the circumstances, it is difficult for the washing liquid to remove sufficiently a native oxide film formed in a bottom portion of the contact hole.

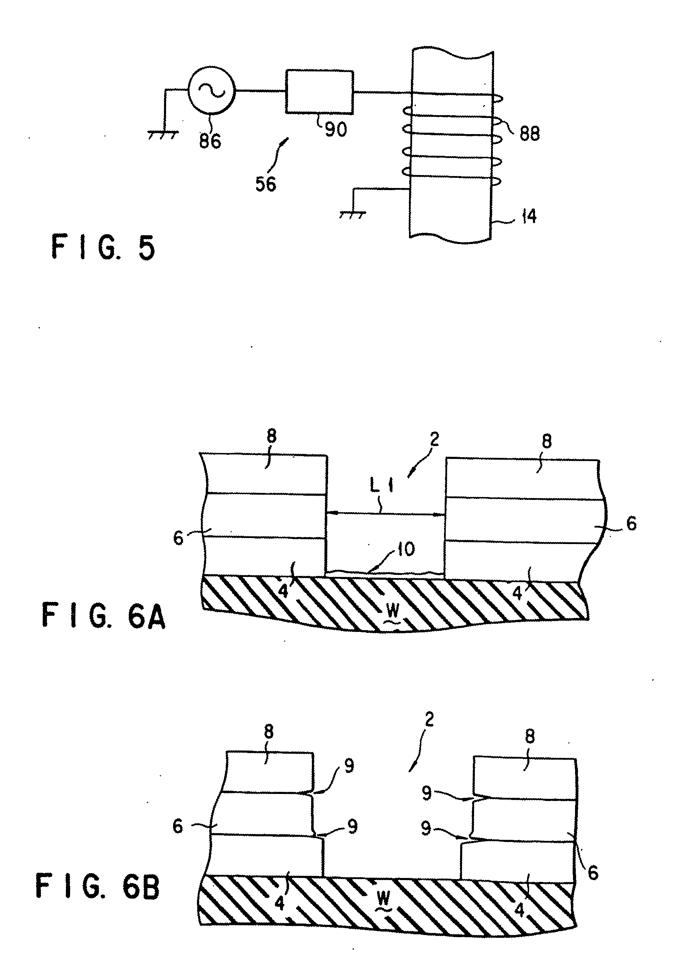

Where the substrate is subjected to a wet washing, the wall of the contact hole is also etched together with the native oxide film. It should be noted in this connection that the contact hole extends through a plurality of layers formed on the substrate, with the result that the wall of the contact hole consists of a plurality of these layers. What should be noted is that these plural layers differ from each other in the etching rate when subjected to etching with the wet washing liquid. It follows that the surface of the contact hole is rendered irregular after the etching with the wet washing liquid. FIGS. 6A and 6B show in detail the situation. Specifically, FIG. 6A shows that a contact hole 2 for achieving an electrical contact with a drain or source region is formed in a surface region of a silicon substrate W. The contact hole 2, which has a diameter of about 0.2 to 0.3 µm, extends through three layers consisting of a SiO₂ λ1 layer 4 formed by thermal oxidation, a phosphorus-doped glass (SiO₂) λ2 layer 6 formed by a spin-coating method, and a silica glass (SiO₂) λ3 layer 8, as shown in the drawing. A native oxide film 10 is formed at the bottom of the contact hole 2. These SiO₂ layers 4, 6 and 8 slightly differ from each other in the etching rate when washed with a washing liquid. It follows that, if the native oxide film 10 is removed by the wet etching, the wall surface of the contact hole 2 is caused to be irregular by the difference in the etching rate noted above, as shown in FIG. 6B. In addition, the washing liquid tends to enter the boundary regions between the adjacent two layers, leading to an overetching of the boundary regions.

To overcome the above-noted difficulties, it is proposed to employ a so-called dry etching method in place of the wet etching method for removing the native oxide film at the bottom of the contact hole. Japanese Patent Disclosure (Kokai) No. 2-256235 discloses a method of removing a native oxide film by utilizing a NF₃ gas (halogen gas) or NH₃ gas (basic gas). It is disclosed that the halogen gas or the basic gas noted above is introduced into a process chamber, and the native oxide film is removed by plasma formed within the process chamber. In this technique, however, required is an apparatus for exhausting these two kinds of the special gases (NF₃, NH₃) leading to a high operating cost.

Japanese Patent Disclosure No. 6-338478 discloses another technique. It is disclosed that a H₂ gas and a H₂O vapor are supplied into a plasma generating section for activation of these gas and vapor. Then, a NF₃ gas or a gaseous mixture containing NF₃ gas is added to the activated gas and vapor for removing the native oxide film. However, since H₂O (steam) is used in this technique, a native oxide film tends to be formed in an amount larger than the amount of the removed native oxide film. As a matter of fact, a native oxide film was not sufficiently removed in the experiment conducted by the present inventor.

An object of the present invention, which has been achieved in an attempt to solve the above-noted problems, is to provide a method and apparatus for effectively removing an oxide film formed on a surface of an object mainly such as a semiconductor wafer.

This object is solved by the provision of a substrate processing apparatus as defined in appending claim 1 and the method as defined in appending claim 9.

The invention can be more fully understood from the following detailed description when taken in conjunction with the accompanying drawings, in which;
FIG. 1 shows the construction of a processing apparatus according to one embodiment of the present invention;
FIG. 2 is a plan view showing a NF₃ gas supply section;
FIGS. 3A to 3C show the processing steps of a processing method of the present invention;
FIG. 4A is a graph showing the result of an elemental analysis on a surface of an object before processing by the method of the present invention;
FIG. 4B is a graph showing the result of an elemental analysis on a surface of an object after processing by the method of the present invention;
FIG. 5 shows a modification of the plasma forming section;
FIGS. 6A and 6B are directed to a conventional method for removing a native oxide film; and
FIG. 7 is a graph showing the relationship between the contact resistance and the contact size.

The present invention is directed mainly to a technique of removing an oxide film formed on a surface of an object such as a semiconductor wafer, particularly, to a technique for removing a native oxide film. Although the object to be processed in the present invention is not limited to a semiconductor wafer, in order to specifically describing a preferred embodiment of the present invention, the present invention in relation to a technique for removing a native oxide film formed in a bottom portion of a fine hole formed on a surface region of a semiconductor wafer is described.

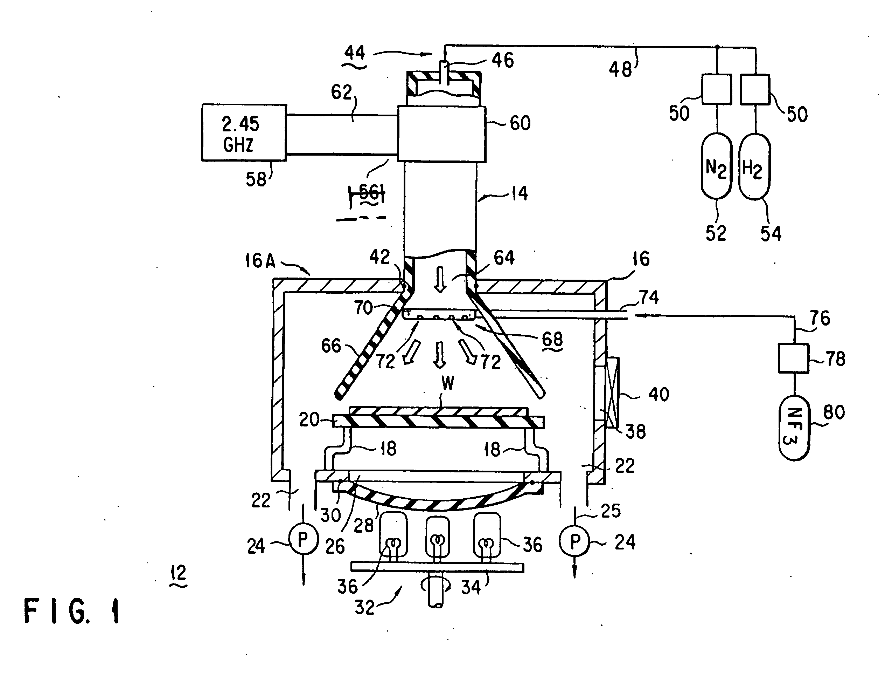

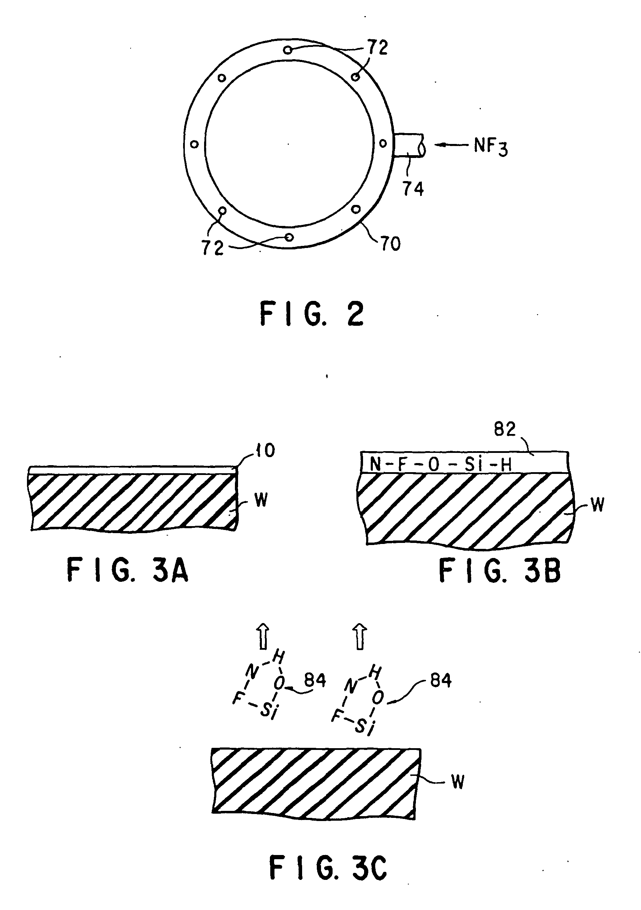

FIG. 1 shows the construction of a processing apparatus 12 of the present invention, and FIG. 2 is a plan view showing a supply section of a NF₃ gas. As shown in the drawings, the processing apparatus 12 comprises a microwave generating source 58, waveguides 60, 62, a gas introducing section 44 for introducing a mixed gas of a N₂ gas and H₂ gas, a pipe 14 for forming a plasma and active species, and a process chamber 16 in which a native oxide film formed on an object (semiconductor wafer) is removed. The microwave formed in the microwave generating source 58 is supplied through the waveguides 62, 60 and the pipe 14 for forming a plasma and active species. Within the pipe 14, the mixed gas of the N₂ gas and H₂ gas is converted into a plasma so as to form active species. The process chamber 16 is in the form of a cylinder made of, for example, aluminum. A susceptor 20 made of, for example, SiC is supported by supporting rods 18 made of, for example, quartz. Formed in a bottom portion of the process chamber 16 is an exhaust port 22, which is connected to an exhaust system 25 equipped with a vacuum pump 24, etc. for evacuating the process chamber 16. An opening 26 equal in size to the susceptor 20 is formed below the susceptor 20. A heat ray transmitting member 28 made of, for example, quartz is hermetically attached to close the opening 26 using a sealing member 30. The heat ray transmitting member 28 is shaped arcuate in cross section in a manner to bend downward in the central portion. A heating means 32 is arranged below the heat ray transmitting member 28 such that the susceptor 20 is heated from the back side. The heating means 32 includes a plurality of heating lamps 36, e.g., halogen lamps, mounted on a rotatable plate 34. The heat emitted from the heating means is transmitted through the heat ray transmitting member 28 so as to be incident on the back surface of the susceptor. Incidentally, heating means other than the heating lamps 36 shown in the drawing can also be used in the present invention. For example, it is possible to mount an electric heater within the susceptor 20. Further, a semiconductor wafer transfer port 38 and a gate valve 40 are formed in a side wall of the process chamber 16.

The pipe 14 for forming a plasma and active species, which is made of an electrically insulating and microwave transmitting material such as quarts, is hermetically mounted to close an upper opening in a ceiling portion 16A of the process chamber 16 using a sealing member 42. Also, the pipe 14 extends through the waveguide 60. The gas introducing section 44 is mounted on the upper end of the pipe 14 such that a mixed gas of a N₂ gas and a H₂ gas is introduced through the gas introducing section 44 and the waveguide 60 into the pipe 14. The gas introducing section 44 includes an introducing nozzle 46, which is connected to a gas passageway 48. The gas passageway 48 is connected to a two-way branched tube, one of the branches being connected to a N₂ gas source 52 via a flow rate controller 50, e.g., mass flow controller, and the other branch being connected to a H₂ gas source 54 via another flow rate controller 50.

The microwave having a frequency of, for example, 2.45 GHz, which is generated in the microwave generating source 58, is supplied through the waveguide 62 having, for example, a rectangular cross section, and the other waveguide 60, e.g., an Evenson type microwave, into the pipe 14 for forming a plasma and active species. The mixed gas of the H₂ gas and N₂ gas is converted into a plasma within the pipe 14 under the action of the microwave so as to form active species of 2N* from N₂ and 2.H* from H₂.

An NF₃ gas supply section 68 is formed in a lower portion of an outlet port 64 of the pipe 14 so as to supply an NF₃ gas into the active species. The NF₃ gas is supplied from an NF₃ gas source 80 into a ring-like shower head 70 made of quartz through a flow rate controller 78, e.g., mass flow controller, a gas passageway 76 and a communicating pipe 74. Then, the NF₃ gas is added through a gas holes 72 to the active species. As a result, the NF₃ itself is also activated by the active species.

A guide member 66 made of quartz and downwardly flared or shaped conical is mounted to the outlet port 64 of the pipe 14 so as to permit the activated gases to be supplied uniformly onto an object to be treated.

The processing method of the present invention is worked by using the processing apparatus of the construction described above. Specifically, an object W (silicon wafer) is introduced into the process chamber 16 through the gate valve 40, which is opened, and disposed on the susceptor 20. The contact hole 2 as shown in FIG. 6A is formed in advance in a surface region of the silicon wafer W. As described previously, a native oxide (SiO₂) film 10 is formed in a bottom of the contact hole 2. FIG. 3A shows in a magnified fashion the native oxide film 10 formed in the bottom of the contact hole 2.

After introduction of the wafer W, the gate valve 40 of the process chamber 16 is closed to make the process chamber hermetic. Under this condition, the process chamber is evacuated to establish a vacuum condition. Then, the N₂ gas and H₂ gas are introduced at predetermined flow rates from the N₂ gas source 52 and the H₂ gas source 54 into the pipe 14 for forming a plasma and active species through the plasma gas introducing section 44. Also, the microwave having a frequency of, for example, 2.45 GHz, which is generated in the microwave generating source 58, is introduced into the pipe 14 through the waveguides 62 and 60. Within the pipe 14, the N₂ gas and the H₂ gas are converted by the microwave into a plasma and, activated to form active species. Since the process chamber 16 is held vacuum, these active species are moved toward the outlet port 64 of the pipe 14.

Further, the NF₃ gas supplied from the NF₃ gas source 80 is added through the ring-like shower head 70 of the NF₃ gas supply section 68 to the active species of the mixed gas of the H₂ gas and N₂ gas, with the result that the NF₃ gas is also activated by the active species so as to form a mixture of these activated gases. The mixture is effectively guided uniformly by the guide member 66 toward the wafer W so as to be brought into contact with the wafer W. As a result, the active species react with the native oxide film on the wafer W to cause the native oxide film to be modified into a reaction film 82 in which Si, N, H, F and O are mixed together, as shown in FIG. 3B. The reaction film 82 also serves to prevent the silicon wafer W itself from being etched with the activated gases. During this treatment, the wafer W is not heated, and is put under room temperature to cause the activated gases to reach a bottom of the contact hole effectively.

For example, the flow rates of the H₂ gas, N₂ gas, and NF₃ gas may be set at 20 sccm, 30 sccm and 200 sccm, respectively. The process pressure may be set at 3 Torr, the plasma power may be set at 150W, and the process time may be set at 3 minutes.

As described previously, the downwardly flared guide member 66 is arranged above the susceptor 20, with the result that scattering of the activated gases is suppressed by the guide member 66. It follows that the activated gases flow effectively toward the wafer so as to perform reaction with the native oxide film formed on the wafer W.

After formation of the reaction film 82, the supply of the H₂ gas, N₂ gas and NF₃ is stopped. Also stopped is the operation of the microwave generating source 58. Then, the process chamber 16 is evacuated to discharge the gases remaining within the process chamber 16 to the outside. Under this condition, the susceptor 20 is heated from the back surface by the heating means 32 so as to elevate the temperature of the wafer W disposed on the susceptor 20 to a predetermined level, e.g., at least 100°C. By this heating, a molecule 84 containing Si, N, H, F and 0 is sublimated so as to be scattered. As a result, the native oxide film 10 is removed from the wafer W to expose the Si substrate to the outside at the bottom of the contact hole. The heat treatment for removing the native oxide film 10 is carried out under a pressure of 1 mTorr or less for about 2 minutes.

The mechanism of the native oxide film removal described above has not yet been clarified sufficiently. However, it is considered reasonable to understand that the activated gases of H₂ gas, N₂ gas and NF₃ gas react with the native oxide film (SiO₂) to form a large molecule containing Si, N, H, F and O. To be more specific, N, F and H are considered to be interposed between O and Si so as to be bonded each other, and the resultant product is considered to be readily sublimated under heat of at least 100°C while maintaining a molecular form of N-F-H-O-Si.

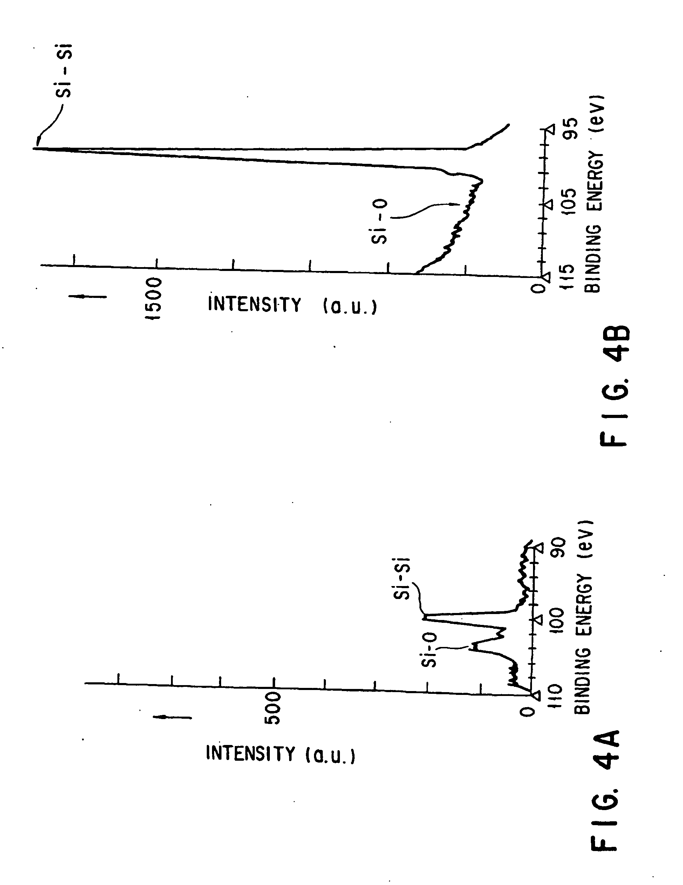

The atoms on the surface of the wafer W thus treated were analyzed by a surface elemental analysis apparatus (XPS, i.e., X-ray Photoelectron Spectroscopy), with the result as shown in FIGS. 4A and 4B. FIG. 4A shows the analytical result of the surface of the semiconductor wafer before the treatment, with FIG. 4B showing the analytical result of the wafer after the treatment of the present invention. As shown in FIG. 4A, a peak of the intensity is recognized in the vicinity of 104 eV of the binding energy, which denotes the Si-O bond, in addition to another peak in the vicinity of 99 eV of the binding energy denoting the Si-Si bond before the process of the present invention. After the process of the present invention, however, a peak is not recognized in the vicinity of 104 eV of the binding energy, which denotes the Si-O bond, though another peak is recognized in the vicinity of 99 eV of the binding energy denoting the Si-Si bond, as shown in FIG. 4B. This clearly supports that the native oxide film (SiO₂) has been completely removed by the treatment of the present invention.

Various experiments have been conducted by changing the process pressure and temperature in sublimating the reaction film 82. It has been found that the upper limit of the process pressure is about 100 mTorr 1 Torr ≙ 133 Pa. If the process pressure was higher than 100 mTorr, the reaction film 82 was not sufficiently sublimated. On the other hand, the lower limit of the process temperature has been found to be about 100°C. If the process temperature was lower than about 100°C, the reaction film 82 was not sufficiently sublimated.

If the native oxide film is removed by the conventional wet washing, the surface of the object after removal of the native oxide film is relatively roughened. However, the surface of the object after removal of the native oxide film by the method of the present invention is rendered flat, compared with the wet washing. It follows that the contact area between the wafer surface after removal of the native oxide film and the surface of the wiring fixed to the wafer surface is increased, leading to a stronger bonding between the two.

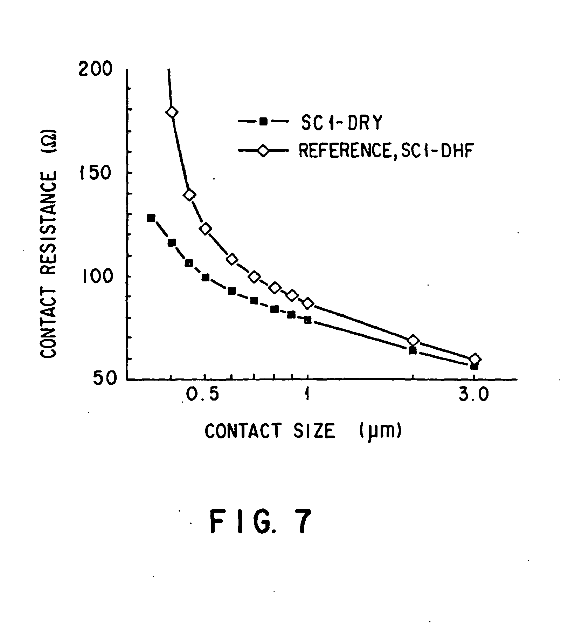

Additional experiments have been conducted in an attempt to confirm the effect produced by the present invention. In these experiment, used as samples were silicon substrates each having a silicon oxide film formed thereon. A contact hole was formed in the silicon oxide film. Further, a doped polycrystalline silicon (polysilicon) wiring was buried in the contact hole for electrical connection to the silicon substrate. Before formation of the polysilicon film, the sample was washed with a washing solution as a pretreatment in order to remove mainly particles. The washing solution consisted of ammonia water, hydrogen peroxide solution, and pure water mixed at a ratio of 1 : 2 : 10.
The washing treatment was carried out at 60°C for 10 minutes. Further, each of the samples was washed with water and, then, dried, followed by dividing the samples into a group of comparative samples and another group of samples to which the method of the present invention was applied. These comparative samples were etched with an etching solution consisting of hydrofluoric acid and pure water mixed at a ratio of 1 : 99. The etching treatment was carried out at room temperature for 10 minutes. The other samples for the present invention were subjected to a dry treatment under the conditions described previously. FIG. 7 shows the experimental data in respect of the contact resistance relative to various contact sizes. The comparative samples are denoted by an SCI-DFH curve in FIG. 7, with the samples for the present invention being denoted by an SCI-DRY curve. The expression "SCI" represents the washing pretreatment which was commonly employed in both the comparative samples and the samples for the present invention. As apparent from FIG. 7, the samples treated by the method of the present invention were lower in the contact resistance than the comparative samples. In addition, the difference in the contact resistance between the comparative samples and the samples for the present invention was prominently increased with decrease in the contact size.

As described above, the processing method and apparatus of the present invention permit removing a native oxide film formed at a bottom of a fine contact hole without using a washing liquid as in the wet washing method. It should also be noted that an NH₃ gas is not used in the present invention, making it possible to disuse an exhaust gas processing apparatus for processing the NH₃ gas. It follows that the facility cost and the operating cost can be reduced in the present invention.

In the present invention, activated gases are formed from an N₂ gas, H₂ gas and NF₃ gas. A surface of an object is exposed to these activated gases to bring about a reaction between these activated gases and an oxide film to be removed, particularly a native oxide film formed on the surface of the object. As a result, the oxide film is converted into a reaction film, which is then sublimated by the heating of the object to a predetermined temperature. It should also be noted that, in the present invention, a mixed gas of a N₂ gas and H₂ gas is converted into a plasma and active species are formed. Further, the NF₃ gas is added to the active species so as to form activated gases of the N₂ gas, H₂ gas and NF₃ gas. Additional features of the present invention are as already described herein before.

For example, a plasma forming section 56 included in the processing apparatus of the present invention is equipped with the microwave generating source 58, the Evenson type waveguide 60, etc., as shown in FIG. 1. The plasma forming section 56 of the particular construction is efficient for forming a plasma of a mixed gas consisting of N₂ gas and H₂ gas. However, it is also possible to substitute the plasma forming section 56 constructed as shown in FIG. 5 for the plasma forming section shown in FIG. 1. To be more specific, the plasma forming section 56 shown in FIG. 5 comprises a high frequency generating source 86 generating RF (Radio Frequency) of 13.56 MHz and a induction coil 88 wound about a part of the pipe 14 for forming plasma and active species. Further, a matching circuit 90 is connected between the induction coil 88 and the high frequency generating source 86 so as to achieve the impedance matching therebetween. In this case, a plasma is formed by an inductive coupling upon supply of an RF wave to the induction coil 88, with the result that the function and effect similar to those in the embodiment described previously are exhibited.

The flow rates of the various gases described previously are no more than examples and, thus, do not limit the technical scope of the present invention.

In the embodiment described previously, the flow rates of the H₂ gas, N₂ gas and NF₃ gas are set at 20 sccm, 30 sccm and 200 sccm, respectively. However, it is possible to double these flow rates or to set the flow rates at levels higher than double of these flow rates.

Also, in the embodiment described previously, the shower head 70 for supplying the NF₃ gas is mounted to the outlet port 64 of the pipe 14 for forming plasma and active species. However, the mounting position of the shower head 70 is not limited to the outlet port 64 noted above. To be more specific, the shower head 70 can be mounted anywhere as far as the mounting position is closer to the object than the waveguide 60. In this case, it is important to add the NF₃ gas to an atmosphere of active species converted from the plasma, not to the plasma of a mixed gas consisting of H₂ gas and N₂ gas. If NF₃ is present within a plasma, the NF₃ gas is excessively activated so as to severely etch the wall made of quarts, i.e., the wall of the pipe 14 for forming plasma and active species.

Further, it is not absolutely necessary for the shower head 70 to have a ring-like structure. For example, pipes having gas holes may be arranged in a lattice shape to form the shower head. Alternatively, a simple gas introducing nozzle can be used in place of the shower head 70.

Further, the embodiment described previously is directed to removal of a native oxide film formed on a silicon substrate. Of course, the present invention can also be employed for removing a native oxide film formed on other substrates or layers. For example, the technique of the present invention can be employed for removing a native oxide film formed on a metal silicide film, e.g., film of WSiₓ, TiSiₓ, CoSiₓ, AlSiₓ or NiSiₓ.

Further, the frequencies of the microwave and RF wave are not limited to those referred to previously. In other words, the microwave and RF wave of different frequencies can also be used in the present invention.

Further, in the embodiment described previously, a native oxide film was removed within the process chamber 16. Of course, it is necessary for at least an oxide film or a native oxide film to be removed within the process chamber 16. However, it is possible to carry out other treatments such as a film-forming treatment and an etching treatment within the process chamber 16 before or after removal of the native oxide film.

Still further, in the embodiment described previously, heating lamps arranged below the back surface of a susceptor were used as a heating means for heating an object, which was disposed on the front surface of the susceptor. Alternatively, an electric heater arranged within the susceptor may be used as the heating means. It is also possible to arrange both an electric heater and a cooling means within the susceptor. The cooling means can be used for cooling the susceptor and the object in order to permit the activated gas to be moved to reach a bottom portion of a fine hole such as a contact hole formed in a surface region of the object. Further, heating lamps arranged above the object can be used for directly heating the surface of the object.

## Claims

1. A substrate processing apparatus which processes a surface of a substrate, the apparatus comprising:
a process chamber 16 for processing a substrate W;
a susceptor 20 which is disposed in the process chamber 16 and mounts the substrate W;
a plasma generating pipe 14 for generating an activated species, one end being connected to an upper portion of the process chamber 16;
a gas introducing section 44 which is connected to the other end of the plasma generating pipe, and supplies a N₂ gas and H₂ gas from a N₂ gas source 52 and H₂ gas source 54;
a plasma generating section 56 for converting the N₂ gas and H₂ gas supplied to the plasma generating pipe 14 into plasma, and generating the activated species;
a NF₃ gas supplying section 68 which is disposed on the upper portion of the process chamber, and supplies a NF₃ gas; and
a vacuum pump 24 for evacuating the process chamber 16,
wherein the apparatus is **characterized in that** the activated species of the N₂ gas and H₂ gas generated in the plasma generating section form a down flow in the plasma generating pipe, and are introduced into the process chamber 16, and
the NF₃ gas supplied from the NF₃ gas supplying section 68 is added to the activated species of the N₂ gas and H₂ gas of the down flow, activated, and supplied to the process chamber 16.

2. The processing apparatus according to claim 1, **characterized in** comprising a heating device for heating said susceptor to a predetermined temperature.

3. The processing apparatus according to claim 2, **characterized in that** said [second] NF₃ gas supply section 68 is provided more downstream than said plasma generating pipe 56.

4. The processing apparatus according to any one of claims 1 to 3, **characterized in that** said [second] NF₃ gas supply section 68 is formed of a nozzle shape, a lattice shape, or a shower head shape.

5. The processing apparatus according to any one of claims 1 to 4 **characterized in that** said plasma generating section 56 comprises a microwave generator 58 for generating microwaves, and a waveguide for introducing the generated microwaves into said plasma generating pipe 14.

6. The processing apparatus according to claims 1 to 4, **characterized in that** said plasma generating section 56 comprises a high frequency generating source 58 generating an RF wave, and an induction coil 88 for introducing the RF wave to said plasma generating pipe 14, wherein the induction coil is connected to said high frequency generating source 58 through a matching circuit.

7. The processing apparatus according to any one of claims 1 to 6, **characterized in that** a [covering] guide member 66 flared downward and communicating with an outlet port of said plasma generating pipe 14 is provided on an upper portion of said susceptor 20.

8. The processing apparatus according to any one of claims 1 to 7, **characterized in that** said plasma generating pipe 14 is formed of quartz.

9. A method of removing an oxide film formed on a surface of a substrate in a process chamber, comprising the steps of:
(a) disposing a substrate W on a susceptor 20 in a process chamber 16;
(b) converting a mixed gas of a N₂ gas and H₂ gas into plasma; and
(c) forming an activated species of the N₂ gas and an activated species of the H₂ gas,
(d) introducing the activated species of the N₂ gas and H₂ gas into the process chamber 16 by forming a down flow to the substrate;
(e) activating a NF₃ gas by adding the NF₃ gas to the activated species of the N₂ gas and H₂ gas of the down flow;
(f) the activated species of the N₂ gas, H₂ gas, and NF₃ gas forming a down flow to the substrate;
(g) forming a reaction film 82 by reacting the activated species of the N₂ gas, H₂ gas, and NF₃ gas with an oxide film 10 formed on the surface of the substrate W;
(h) removing the oxide film by heating and sublimating the reaction film.

10. The method according to claim 9, **characterized in that** the method comprises the step of stopping supplying said N₂ gas and H₂ gas, NF₃ gas and plasma after said step [(c)] g is finished, and removing residual gas by evacuating said process chamber 16.

11. The method according to any one of claims 9 or 10, **characterized in that** in said step [(d)] h, the temperature of said object to be processed is 100°C or higher.

12. The method according to any one of claims 9 to 11, **characterized in that** in said step [(d)] h, the pressure of said process chamber 16 a 100 mTor or less.

13. The method according to any one of claims 9, to 12; **characterized in that** said each step (a) - (g) is carried out at room temperature.

14. The method according to any one of claims 9 to 13, wherein said oxide film is a native oxide film formed on silicone or metal silicide.

15. The method according to claim 14, wherein said metal silicide is selected from WSiₓ, TiSiₓ, CoSiₓ, and NiSiₓ.

16. The method according to any one of claims 9 to 15, **characterized in that** the reaction film 82 including Si, N, H, F, and O.

17. The method according to any one of claims 9 to 16, **characterized in that** said plasma is a plasma generated in a microwave or a high frequency electromagnetic wave.

18. The method according to claim 9 to 17, the method further comprising the steps of:
cleaning an object to be processed by using a cleaning liquid having ammonia and hydrogen peroxide, the object having an oxide film formed thereon.

19. The method according to claim 9, wherein the oxide film is a native oxide film formed on a lower portion of a contact hole 2 formed on the surface of the substrate.

20. The method according to claim 9, wherein the step (e) is carried out at room temperature.

21. The method according to claim 9, wherein the step (f) is carried out under a vacuum condition.

## Patentansprüche

1. Substratbearbeitende Vorrichtung, welche eine Oberfläche eines Substrats bearbeitet und umfasst:
eine Prozesskammer 16 zur Bearbeitung eines Substrates W,
einen Aufnehmer 20, der in der Prozesskammer angeordnet ist und an dem das Substrat W angebracht ist;
eine plasmagenerierende Röhre 14 zur Generierung einer aktivierten Spezies, von der ein Ende mit einem oberen Teil der Prozesskammer 16 verbunden ist;
einen Gaseinleitungsabschnitt 44, der mit dem anderen Ende der plasmagenerierenden Röhre verbunden ist und N₂-Gas und H₂-Gas von einer N₂-Gasquelle 52 und H₂-Quelle 54 zuführt;
einen plasmagenerierenden Abschnitt 56 zur Umwandlung des der plasmagenerierende Röhre 14 zugeführten N₂-Gases und H₂-Gases in Plasma und Generierung der aktivierten Spezies;
einen NF₃-Gas-Zuführungsabschnitt 68, der im oberen Abschnitt der Prozesskammer angeordnet ist und NF₃-Gas zuführt; und
eine Vakuumpumpe 24 zur Evakuierung der Prozesskammer 16,
wobei die Vorrichtung **dadurch gekennzeichnet ist, dass** die aktivierten Spezies des N₂-Gases und H₂-Gases, die in dem plasmagenerierenden Abschnitt generiert werden, einen Abwärtsstrom in der plasmagenerierenden Röhre bilden, und in die Prozesskammer 16 eingeführt werden, und
das NF₃-Gas, das von dem NF₃-Gaszuführungsabschnitt 68 zugeführt wird, zur aktivierten Spezies des N₂-Gases und H₂-Gases des Abwärtsstroms zugegeben, aktiviert und der Prozesskammer 16 zugeführt wird.

2. Bearbeitungsvorrichtung gemäß Anspruch 1, **dadurch gekennzeichnet, dass** sie ein Heizgerät zum Heizen des Aufnehmers auf eine vorgegebene Temperatur enthält.

3. Bearbeitungsvorrichtung gemäß Anspruch 2, **dadurch gekennzeichnet, dass** der (zweite) NF₃-Gaszuführungsabschnitt 68 stromabwärts der plasmagenerierenden Röhre 56 vorgesehen ist.

4. Bearbeitungsvorrichtung gemäß einem der Ansprüche 1 bis 3, **dadurch gekennzeichnet, dass** der (zweite) NF₃-Gaszuführungsabschnitt 68 in Düsenform, Gitterform oder Duschkopfform vorgesehen ist.

5. Bearbeitungsvorrichtung gemäß einem der Ansprüche 1 bis 4, **dadurch gekennzeichnet, dass** der plasmagenerierende Abschnitt 56 einen Mikrowellengenerator 58 zur Generierung von Mikrowellen und einen Hohlleiter zur Einführung der generierten Mikrowellen in die plasmagenerierende Röhre 14 enthält.

6. Bearbeitungsvorrichtung gemäß Anspruch 1 bis 4, **dadurch gekennzeichnet, dass** der plasmagenerierende Abschnitt 56 eine hochfrequenzgenerierende Quelle 58, die eine RF-Welle generiert, und eine Induktionsspule 88 zur Einführung der RF-Welle in die plasmagenerierende Röhre 14 enthält, wobei die Induktionsspule mit der hochfrequenzgenerierenden Quelle 58 durch einen passenden Stromkreis verbunden ist.

7. Bearbeitungsvorrichtung gemäß einem der Ansprüche 1 bis 6, **dadurch gekennzeichnet, dass** ein abdeckendes, nach unten sich aufweitendes Führungsbauteil, das mit einer Auslassöffnung der plasmagenerierenden Röhre 14 verbunden ist, in einem oberen Bereich des Aufnehmers 20 vorgesehen ist.

8. Bearbeitungsvorrichtung gemäß einem der Ansprüche 1 bis 7, **dadurch gekennzeichnet, dass** die plasmagenerierende Röhre 14 aus Quarz gebildet ist.

9. Verfahren zur Entfernung eines auf der Oberfläche des Substrats gebildeten Oxidfilms in einer Prozesskammer, umfassend die Schritte:
(a) Anbringen des Substrats W auf einen Aufnehmer 20 in einer Prozesskammer 16;
(b) Umwandeln eines Gasgemisches aus N₂-Gas und H₂-Gas in Plasma; und
(c) Bilden einer aktivierten Spezies des N₂-Gases und einer aktivierten Spezies des H₂-Gases;
(d) Einführung der aktivierten Spezies des N₂-Gases und H₂-Gases in die Prozesskammer 16 durch Bilden eines Abwärtsstroms zum Substrat;
(e) Aktivierung eines NF₃-Gases durch Zugabe des NF₃-Gases zu den aktivierten Spezies des N₂-Gases und H₂-Gases des Abwärtsstroms;
(f) die aktivierten Spezies des N₂-Gases, H₂-Gases und NF₃-Gases bilden einen Abwärtsstrom zum Substrat;
(g) Bilden eines Reaktionsfilms 82 durch Reaktion der aktivierten Spezies des N₂-Gases, H₂-Gases und NF₃-Gases- mit einem auf der Oberfläche des Substrates W gebildeten Oxidfilms 10,;
(h) Entfernen des Oxidfilms durch Erwärmen und Sublimieren des Reaktionsfilms.

10. Verfahren gemäß Anspruch 9, **dadurch gekennzeichnet, dass** das Verfahren den Schritt enthält, dass die Zufuhr von N₂-Gas und H₂-Gas, NF₃-Gas und Plasma, nachdem der Schritt [(c)] g beendet ist, gestoppt wird, und das restliche Gas durch-Evakuierung der Prozesskammer 16 entfernt wird.

11. Verfahren gemäß einem der Ansprüche 9 oder 10, **dadurch gekennzeichnet, dass** im Schritt [(d)] h die Temperatur des zu bearbeitenden Gegenstandes 100°C oder höher ist.

12. Verfahren gemäß einem der Ansprüche 9 bis 11, **dadurch gekennzeichnet, dass** im Schritt [(d)] h der Druck der Prozesskammer 16 100 mTorr oder weniger beträgt.

13. Verfahren gemäß einem der Ansprüche 9 bis 12, **dadurch gekennzeichnet, dass** jeder Schritt (a) bis (g) bei Raumtemperatur ausgeführt wird.

14. Verfahren gemäß einem der Ansprüche 9 bis 13, wobei der Oxidfilm ein nativer Oxidfilm ist, der auf Silizium oder Metall-Silicid gebildet wird.

15. Verfahren gemäß Anspruch 14, wobei das Metall-Silicid ausgewählt ist aus WSiₓ, TiSiₓ, Cosiₓ und NiSiₓ.

16. Verfahren gemäß einem der Ansprüche 9 bis 15, **dadurch gekennzeichnet, dass** der Reaktionsfilm 82 Si, N, H, F und O enthält.

17. Verfahren gemäß einem der Ansprüche 9 bis 16, **dadurch gekennzeichnet, dass** das Plasma ein Plasma ist, das in einer Mikrowelle oder hochfrequenzelektromagnetischen Welle generiert wird.

18. Verfahren gemäß einem der Anspruche 9 bis 17, das weiterhin die Schritte enthält:
Reinigung des zu bearbeitenden Gegenstandes durch Verwendung einer Reinigungsflüssigkeit, enthaltend Ammoniak und Wasserstoffperoxid, wobei der Gegenstand einen darauf gebildeten Oxidfilm aufweist.

19. Verfahren gemäß Anspruch 9, wobei der Oxidfilm ein nativer Oxidfilm ist, der auf einem unteren Abschnitt eines auf der Oberfläche des Substrats gebildeten Kontaktloches 2 ausgebildet ist.

20. Verfahren gemäß Anspruch 9, wobei der Schritt (e) bei Raumtemperatur ausgeführt wird.

21. Verfahren gemäß Anspruch 9, wobei der Schritt (f) unter Vakuumbedingungen ausgeführt wird.

## Revendications

1. Appareil pour traiter un substrat qui traite une surface d'un substrat, l'appareil comprenant :
une chambre de traitement 16 pour traiter un substrat W ;
un suscepteur 20 qui est placé dans la chambre de traitement 16 et supporte le substrat W ;
un tuyau générateur de plasma 14 pour générer une espèce activée, dont l'une des extrémités est connectée à une partie supérieure de la chambre de traitement 16 ;
une section d'introduction de gaz 44 qui est connectée à l'autre extrémité du tuyau générateur de plasma, et fournit un gaz N₂ et un gaz H₂ provenant d'une source de gaz N₂ 52 et d'une source de gaz H₂ 54 ;
une section génératrice de plasma 56 pour convertir le gaz N₂ et le gaz H₂ introduits dans le tuyau générateur de plasma 14 en plasma, et générer les espèces activées ;
une section d'alimentation en gaz NF₃ 68 qui est disposée sur la partie supérieure de la chambre de traitement, et fournit un gaz NF₃ ; et
une pompe à vide 24 pour mettre la chambre de traitement 16 sous vide,
dans lequel l'appareil est **caractérisé en ce que** les espèces activées du gaz N₂ et du gaz H₂ générées dans la section génératrice de plasma forment un courant descendant dans le tuyau générateur de plasma, et sont introduites dans la chambre de traitement 16, et
le gaz NF₃ fourni par la section d'alimentation en gaz NF₃ 68 est ajouté aux espèces activées du gaz N₂ et du gaz H₂ du courant descendant, activé, et introduit dans la chambre de traitement 16.

2. Appareil de traitement selon la revendication 1, **caractérisé en ce qu'**il comprend un dispositif de chauffage pour chauffer ledit suscepteur à une température prédéterminée.

3. Appareil de traitement selon la revendication 2, **caractérisé en ce que** ladite [seconde] section d'alimentation en gaz NF₃ 68 est plus en aval que ledit tuyau générateur de plasma 56.

4. Appareil de traitement selon l'une quelconque des revendications 1 à 3, **caractérisé en ce que** ladite [seconde] section d'alimentation en gaz NF₃ 68 est formée sous la forme d'une buse, sous la forme d'un treillis, ou sous la forme d'un pommeau de douche.

5. Appareil de traitement selon l'une quelconque des revendications 1 à 4, **caractérisé en ce que** ladite section génératrice de plasma 56 comprend un générateur de micro-ondes 58 pour générer des micro-ondes, et un guide d'ondes pour introduire les micro-ondes générées dans ledit tuyau générateur de plasma 14.

6. Appareil de traitement selon les revendications 1 à 4, **caractérisé en ce que** ladite section génératrice de plasma 56 comprend une source génératrice de hautes fréquences 58 générant une onde RF, et une bobine d'induction 88 pour introduire l'onde RF dans ledit tuyau générateur de plasma 14, dans lequel la bobine d'induction est connectée à ladite source génératrice de hautes fréquences 58 via un circuit d'adaptation.

7. Appareil de traitement selon l'une quelconque des revendications 1 à 6, **caractérisé en ce qu'**un élément de guidage [couvrant] 66 évasé vers le bas et communicant avec un orifice de sortie dudit tuyau générateur de plasma 14 est présent sur une partie supérieure dudit suscepteur 20.

8. Appareil de traitement selon l'une quelconque des revendications 1 à 7, **caractérisé en ce que** ledit tuyau générateur de plasma 14 est en quartz.

9. Procédé pour éliminer un film d'oxyde formé sur une surface d'un substrat dans une chambre de traitement, comprenant les étapes consistant à :
(a) placer un substrat W sur un suscepteur 20 dans une chambre de traitement 16 ;
(b) convertir un gaz mixte à base de gaz N₂ et de gaz H₂ en plasma ; et
(c) former une espèce activée du gaz N₂ et une espèce activée du gaz H₂ ;
(d) introduire les espèces activées du gaz N₂ et du gaz H₂ dans la chambre de traitement 16 en formant un courant descendant vers le substrat ;
(e) activer un gaz NF₃ en ajoutant le gaz NF₃ aux espèces activées du gaz N₂ et du gaz H₂ du courant descendant ;
(f) les espèces activées du gaz N₂, du gaz H₂, et du gaz NF₃ formant un courant descendant vers le substrat ;
(g) former un film réactionnel 82 en faisant réagir les espèces activées du gaz N₂, du gaz H₂, et du gaz NF₃ avec un film d'oxyde 10 formé sur la surface du substrat W ;
(h) éliminer le film d'oxyde en chauffant et en sublimant le film réactionnel.

10. Procédé selon la revendication 9, **caractérisé en ce que** le procédé comprend l'étape consistant à stopper l'alimentation en lesdits gaz N₂ et gaz H₂, gaz NF₃ et plasma après que ladite étape [(c)] g est terminée, et à éliminer le gaz résiduel en mettant ladite chambre de traitement 16 sous vide.

11. Procédé selon l'une quelconque des revendications 9 ou 10, **caractérisé en ce que**, dans ladite étape [(d)] h, la température dudit objet à traiter est de 100°C ou plus.

12. Procédé selon l'une quelconque des revendications 9 à 11, **caractérisé en ce que**, dans ladite étape [(d)] h, la pression de ladite chambre de traitement 16 est de 100 mTorr ou moins.

13. Procédé selon l'une quelconque des revendications 9 à 12, **caractérisé en ce que** chacune desdites étapes (a) - (g) est mise en oeuvre à température ambiante.

14. Procédé selon l'une quelconque des revendications 9 à 13, dans lequel ledit film d'oxyde est un film d'oxyde natif formé sur une silicone ou une siliciure métallique.

15. Procédé selon la revendication 14, dans lequel ladite siliciure métallique est choisie parmi WSiₓ, TiSiₓ, CoSiₓ, et NiSiₓ.

16. Procédé selon l'une quelconque des revendications 9 à 15, **caractérisé en ce que** le film réactionnel 82 contient du Si, N, H, F, et O.

17. Procédé selon l'une quelconque des revendications 9 à 16, **caractérisé en ce que** ledit plasma est un plasma généré dans une onde électromagnétique de type micro-onde ou haute fréquence.

18. Procédé selon les revendications 9 à 17, le procédé comprenant, en outre, les étapes consistant à :
nettoyer un objet qui doit être traité en utilisant un liquide de nettoyage contenant de l'ammoniaque et du peroxyde d'hydrogène, l'objet portant un film d'oxyde qui s'est formé dessus.

19. Procédé selon la revendication 9, dans lequel le film d'oxyde est un film d'oxyde natif formé sur une partie inférieure d'un trou de contact 2 formé sur la surface du substrat.

20. Procédé selon la revendication 9, dans lequel l'étape (e) est mise en oeuvre à température ambiante.

21. Procédé selon la revendication 9, dans lequel l'étape (f) est mise en oeuvre dans une condition de vide.
